# EUROPEAN PATENT APPLICATION

(11) **EP 4 752 633 A2**
(43) Date of publication of application: **03.06.2026**
(21) Application number: 26170552.9
(22) Date of filing: 02.04.2026
(51) Int. Cl.: G03F 7/00, G03F 9/00, H10W 90/00

(54) **A CONTROL METHOD TO IMPROVE CO-PLANARITY OF MICROBUMPS ACROSS A WAFER OR DIE**

(71) Applicant: ASML Netherlands B.V., 5500 AH Veldhoven (NL)
(72) Inventor: TEN BERGE, Peter, 5500 AH Veldhoven (NL); SINGH, Saurabh, 5500 AH Veldhoven (NL)
(74) Representative: ASML Netherlands B.V.

(57) **Abstract**

An exposure apparatus arranged for preparing a current wafer for creation of microbumps in a subsequent volume-additive process, wherein the exposure apparatus comprises a wafer table arranged for holding the current wafer having a photoresist layer provided on top of the wafer, a patterning device arranged for exposing the photoresist according to a pattern such that, after a further processing step of the photoresist layer, a plurality of openings in the photoresist layer, thereby exposing corresponding sections of the current wafer through the plurality of openings and a controller arranged for receiving dimension data of a plurality of microbumps created in a volume-additive process for a previous wafer and adjusting one or more exposure parameters of the patterning device based on the dimension data.

## Description

### FIELD

The present disclosure relates to the field of semiconductor manufacturing and more particularly to the preparation of a wafer for a subsequent volume-additive process wherein microbumps are created.

### BACKGROUND

High-bandwidth memories, HBM's, have been developed for enabling data-intensive computing, including artificial intelligence, AI, accelerators, high-performance computing, and advanced graphics systems. Typical HBM devices comprise vertically stacked dynamic random-access memory dies interconnected through dense vertical interconnect structures and, in many implementations, a bottom buffer die that interfaces to a logic device or interposer. As performance requirements increase, so does the demand for higher interconnect density to support wider I/O and elevated data throughput between stacked dies.

To realize such vertical interconnect density, industry commonly employs microbump technology, in which, typically, copper pillars form the electrical and mechanical connections between adjacent (stacked) dies during die-to-wafer, D2W, or die-to-die, D2D, stacking. Advancements in AI workloads and large-area packages, such as AI engines and image sensors, are one of the reasons for continuously reducing microbump pitch and diameter while simultaneously increasing the number of interconnects per unit area.

One of the parameters that may affect stacking yield is co-planarity which is the effective flatness or uniformity of the top surfaces of the microbumps across the relevant area (e.g., a wafer, reticle field, or individual die). Inadequate co-planarity may be interpreted as height variation among microbumps that prevents simultaneous, consistent contact across all interconnects during bonding. This condition can lead to incomplete wetting, cold joints, solder starvation, local overstress of taller pillars, and even non-contact for shorter pillars. The resulting defects can reduce electrical continuity, degrade mechanical integrity, and, in some cases, may even render the stacked device nonfunctional. Although in the above the problem of co-planarity of microbumps is explained in the context of HBM, this problem may occur for any wafer or die on top of which a plurality of microbumps is created.

Co-planarity variation may arise from multiple, interacting sources throughout wafer fabrication and assembly. On-wafer factors can include thickness non-uniformity of dielectric layers, seed and barrier metallization, electroplated Cu pillar growth variation, resist patterning non-uniformity, and dishing or erosion during planarization steps.

Existing approaches to address co-planarity typically involve a combination of process control and metrology. Process controls may include tighter electroplating uniformity, optimized resist and under-bump metallization, UBM, stacks. Metrology and inspection, such as optical profilometry, white-light interferometry, and advanced 3D inspection, may be used to quantify pillar height distribution and detect out-of-spec features prior to assembly. While these techniques can reduce variation, continued scaling trends in interconnect pitch and the increasing die sizes in advanced packages strain conventional margins. As a result, there remains a need for further improvements that more effectively control co-planarity across a wafer.

Following the above, there is a need for methods and corresponding exposure apparatuses that improve microbump co-planarity in wafers or dies, for example advanced stacked memory systems, particularly for HBM architectures with fine-pitch, high-count interconnects over large areas.

### SUMMARY

In a first aspect of the present disclosure, there is provided an exposure apparatus arranged for preparing a current wafer for creation of microbumps in a subsequent volume-additive process. The exposure apparatus comprises a wafer table arranged for holding the current wafer having a photoresist layer provided on top of the wafer and a patterning device arranged for exposing the photoresist according to a pattern such that, after a further processing step of the photoresist layer, a plurality of openings in the photoresist layer are formed, thereby exposing corresponding sections of the current wafer.

The exposure apparatus further comprises a controller arranged for receiving dimension data of a plurality of microbumps created in a volume-additive process for a previous wafer, and for adjusting one or more exposure parameters of the patterning device based on the dimension data, such that dimensions of the plurality of the plurality of openings to be formed and corresponding exposed sections of the current wafer are adjusted for improving co-planarity of microbumps created in the subsequent volume-additive process.

Before the details of the exposure apparatus are explained in detail, first a process flow is described.

Microbump structures are typically created on semiconductor wafers by means of a patterning and volume-additive metallization process. The process generally begins with a wafer on which a seed layer has already been deposited. The seed layer, which may comprise a thin film of copper, titanium, titanium-tungsten, or similar conductive materials, provides both electrical conductivity and adhesion for subsequent electroplating.

A photoresist layer is then applied over the wafer surface, typically by spin-coating. The wafer coated with photoresist is received by the wafer table of the exposure apparatus, where the photoresist layer is patterned. During exposure, selected regions of the photoresist are illuminated, for example, through a photomask. The exposure pattern corresponds to the eventual locations of the microbumps. Following exposure, the photoresist is developed, removing either the exposed or unexposed portions depending on whether a positive or negative resist is used. This results in the formation of a plurality of openings in the photoresist layer. The openings define the three-dimensional mold in which the microbump pillars will be formed, and expose corresponding sections of the underlying seed layer.

The exposed sections of the wafer, more specifically the seed layer, are thus the areas on which the microbumps will be created. For the fabrication of a volume-additive technique is employed. One widely used volume-additive process is electroplating, which allows controlled growth of copper pillars within the patterned resist cavities, i.e. the openings in the photoresist layer.

Electroplating is typically performed on dedicated equipment. During electroplating, the wafer is immersed in an electrolyte bath containing dissolved metal ions. The seed layer on the wafer acts as the cathode of the electrochemical system, while an external anode may also be placed in the solution. When an electrical potential is applied between the anode and the seed layer, metal ions in the electrolyte are reduced onto the exposed seed-layer regions.

Metal deposition occurs selectively within the photoresist openings because those regions are the only points where the wafer, more specifically the conductive seed layer, is exposed. As current flows, copper accumulates upward from the seed layer surface, gradually filling the openings in the photoresist layer. The height of the plated copper pillar can be controlled by adjusting all kinds of parameters, for example plating time, current density, bath composition, temperature, etc.

Once the desired copper pillar target height has been reached, the wafer may be removed from the plating tool and rinsed. The photoresist layer may then be stripped, leaving behind free-standing copper microbumps on the underlying wafer. A subsequent etch step may be performed to remove the now-exposed seed layer between microbumps.

The inventors have found that it may be beneficial to incorporate a feedback mechanism to the controller. This entails that the controller will receive dimension data of a plurality of microbumps created in a volume-additive process for a previous wafer. The dimension data may thus reflect the co-planarity of the plurality of microbumps that were created in the previous wafer. The dimension data may encompass height levels of each of the microbumps that were created in the volume-additive process for the previous wafer.

The controller may use this information to adjust one or more exposure parameters to improve the co-planarity of the microbumps that are going to be created for the *current* wafer. The present disclosure is thus not directed to improve the co-planarity of microbumps that are already created. The present disclosure is directed to improve the co-planarity of microbumps that are to be created based on microbumps that have been created in previous wafers.

The step of adjusting the one or more exposure parameters may include translating the dimension data to the two-dimensional, 2D, data of each of the plurality of openings to be formed and/or the corresponding exposed sections of the current wafer. This may be explained as follows.

The volume-additive process is, typically, a process in which the deposited volume of material is constant. The height of the microbumps then depends on the x and y dimensions of each of the plurality of openings and/or the corresponding exposed sections of the wafer.

In accordance with the present disclosure, the controller is arranged for receiving the dimension data of the plurality of microbumps created in the volume-additive process for the previous wafer.

This may be accomplished in various ways. As mentioned above, the dimension data may be created in an apparatus different to the exposure apparatus, for example a wafer plating tool, an electroplating system or a scanner metrology or by an alternative measurement equipment. This apparatus may comprise a levelling sensor arranged for obtaining the dimension data of the plurality of microbumps created in the volume-additive process for a particular wafer. Thus, once the microbumps are created, the levelling sensor may measure the height profile of the microbumps thereby obtaining the dimension data. This may be accomplished in the same apparatus as the one where the volume-additive process takes place or it may be accomplished in an even further apparatus.

The dimension data may then be provided to the controller of the exposure apparatus, for example via an Application Programming Interface, API, a data output, or something similar. In an example, the wafer table is further arranged for holding the previous wafer and wherein the exposure apparatus comprises a levelling sensor arranged for obtaining the dimension data of the plurality of microbumps created in the volume-additive process for the previous wafer.

The above entails that once the microbumps have been created, the wafer may be inserted again into the exposure apparatus. The levelling sensor provided in the exposure apparatus may then obtain the dimension data of these created plurality of microbumps.

In accordance with the present disclosure, the terminology of a pillar and a microbump may be used interchangeably. Microbumps may be used as vertical electrical and mechanical interconnects in advanced semiconductor packaging. They provide the physical connection between one semiconductor die, or wafer, and another die or wafer. In modern devices, multiple dies, such as logic chips, memory stacks, image sensors, or accelerators, may need to communicate with very high bandwidth and low latency. Microbumps enable this by creating thousands of fine-pitch metal connections across the surface of the die. These structures may be of importance in technologies such as high-bandwidth memory. HBM, 3D DRAM stacking, logic-memory integration, chiplet-based architectures, image sensor stacking, and advanced interposer-based systems.

The microbumps may comprise solder bumps, i.e. a solderable top surface, for making the specific solderable connection.

In a further example, the controller is further arranged for spatially aligning the received dimension data of the previous wafer with the plurality of openings to be formed by the patterning device in the current wafer.

In a further example, the one or more exposure parameters comprise any of focus settings and dose control.

The focus setting may determine the position of the exposure plane relative to the photoresist surface. Photolithography may rely on projecting an optical pattern onto a relatively thin photoresist layer, such that even small deviations in wafer topography or lens-to-wafer spacing can distort the pattern. The focus setting compensates for these variations by adjusting the vertical, i.e. Z-axis, position of the wafer stage or the projection optics, thereby ensuring that the image is sharply resolved at the resist layer. Focus control may be used for improving the critical-dimension, CD, of each of the plurality of holes.

In microbump fabrication, where openings in the photoresist serve as the mold for electroplated pillars, adjusting the focus setting in the exposure tool can result in variations in opening width or taper angle, such that it is possible to therewith adjust the height of the microbumps to be formed.

Dose control may refer to the regulation of the total amount of optical energy delivered to the photoresist during exposure. The exposure dose determines how much of the photochemical reaction in the resist is activated. In a positive resist, insufficient dose leads to incomplete solubility change, causing, for example, narrow holes. Excessive dose can cause resist over-exposure causing, for example, broadened holes. In negative resists, the relationships are reversed, but dose remains of importance to achieving desired dimensions of each of the plurality of holes.

In another example, the wafer table is arranged for holding the wafer comprising a seed layer, wherein the photoresist layer is provided on top of the seed layer, wherein the seed layer is arranged to enabling microbumps to be created in a subsequent electroplating process.

In creating the microbump, the seed layer may be considered a thin conductive film deposited on the wafer surface before photoresist patterning. Its function is to provide a continuous, low-resistance electrical path across the wafer so that the subsequent electroplating process can occur uniformly within the patterned openings.

During electroplating, the seed layer may act as the electrode on which metal ions from the electrolyte bath are reduced and deposited, allowing copper pillars to grow only in the regions exposed through the patterned photoresist. Once electroplating is complete and the photoresist mold is removed, the seed layer remains exposed between the plated structures. A subsequent etching step may be performed to remove the seed layer from areas not covered by the plated pillars, electrically isolating the microbumps.

In another example, the levelling sensor is further arranged for obtaining surface topography of each of the plurality of sections of the wafer through the plurality of openings.

The levelling sensor may be used to scan the surface of the wafer to determine its local topography. The inventors have found that it is not only the dimension data of the holes that determines the height of the microbumps that are to be created but that the topography of the exposed sections of the wafer may also contribute thereto. Wafers may not be perfectly flat. Variations may arise from film-thickness non-uniformities, pattern-dependent topography, warpage, or stresses accumulated during processing.

A height-levelling sensor may measure these variations by detecting the vertical, i.e. Z-axis, position of the wafer surface at many points across the exposure field, at least at the exposed sections of the wafer. This measurement may be performed using optical triangulation, interferometry, capacitive probes, or through-beam reflection techniques.

The controller may then further be arranged for adjusting the one or more exposure parameter of the patterning device based on the surface topography.

In a further example, the controller is further arranged for receiving Side Wall Angle, SWA, data of the photoresist layer corresponding to each of the plurality of openings.

The controller may be arranged for adjusting the one or more exposure parameter of the patterning device based on the received SWA data.

A technique for measuring the sidewall angle of photoresist openings is critical-dimension scanning electron microscopy, CD-SEM. In this method, the patterned wafer may be placed in a SEM chamber where a finely focused electron beam scans across the resist. As the beam interacts with the resist profile, variations in secondary-electron intensity reveal differences in topography. By collecting images at different beam energies or tilt angles, the CD-SEM reconstructs the shape of the resist opening, including the top and bottom critical dimensions and the slope of the sidewall. This enables determination of whether the resist walls are vertical, tapered, or re-entrant.

Another method may be optical scatterometry. In this approach, polarized light with multiple wavelengths is directed onto the patterned resist. The periodic structures in the resist cause the light to diffract, and the reflected diffraction spectrum is captured by the tool. The measured spectrum is then compared to a physics-based optical model that describes how the resist profile interacts with light. By adjusting the model until it matches the measured spectrum, the system extracts detailed geometric parameters of the resist shape, including the sidewall angle.

The above mentioned measurement may be performed from a top side of the wafer or on a cross section of the wafer with side view. Alternatively, the measurements may be performed on the manufactured microbumps / pillars as it is then a measurement on the result after the manufacturing process that needs to be adjusted. This may provide more accurate results of the SWA.

In another example, the exposure apparatus is any of a stepper apparatus or a scanner apparatus.

A stepper apparatus may be considered a lithography system in which the exposure of the photoresist takes place in a static manner. In a stepper, the projection optics expose one field, i.e. die area, at a time by projecting a full-field or reduced-field image of the photomask onto the wafer without relative motion during exposure. After one field is exposed, the wafer stage "steps" to the next position, and the process is repeated field by field.

A scanner performs exposure through a continuous scanning motion of the reticle and the wafer stage. In a scanner, the photomask and wafer move synchronously but in opposite directions while the slit-shaped exposure beam passes over the field. The projection optics maintain image fidelity as this coordinated motion effectively "sweeps" the pattern across the wafer.

In an example, the exposure apparatus is the scanner apparatus, and the scanner apparatus comprises a levelling sensor for mapping wafer surface thereby obtaining wafer topography, and wherein the controller is configured adjust focus and/or tilt of the patterning device during scanning exposure based on the obtained wafer topography map, thereby exposing photoresist according to the pattern.

In accordance with the present disclosure, the controller is arranged to adjusting one or more exposure parameters of the patterning device based on the dimension data. This may be accomplished in a variety of ways.

In certain accordance with the present disclosure, the patterning device may comprise multiple subsystems of the exposure apparatus, including for example a reticle stage, a wafer stage, and a projection system. The reticle stage may be arranged to position the patterning substrate (e.g., a reticle or mask) in at least the lateral X-, Y-, direction and the vertical Z-direction. The wafer stage may be arranged to support and position the substrate (e.g., a wafer) and may provide motion in X, Y, Z, and may provide rotational directions. The projection system may comprise one or more optical elements arranged to project the patterned radiation from the reticle onto the resist layer. Collectively, these subsystems may form the patterning device because, in combination, they determine how the pattern is transferred to the photoresist and how one or more exposure parameters are realized during scanning or stepping exposure.

The term exposure parameters may refer to parameters that influence how the pattern is exposed onto the resist layer. Such exposure parameters may include, among others, focus settings of the patterning device, which may determine the axial position of the image plane with respect to the substrate surface, as well as dose control parameters, which determine the total energy delivered to each point of the photoresist. Adjusting these exposure parameters may involve coordinated control of the illumination system, projection system, reticle stage, and wafer stage.

In examples, adjusting the focus setting involves controlling the axial position of the image plane relative to the substrate surface. To achieve this, the reticle stage and/or the wafer stage may be moved in the Z-direction, optionally in combination with small rotational motions (e.g., Rx and Ry), such that the wafer surface is brought into the appropriate focal position. Alternatively or additionally, elements of the projection system may be adjusted to shift or maintain the focal plane at a desired position. Thus, movement of the reticle stage, wafer stage, or projection optics in the Z-direction may be considered part of adjusting one or more exposure parameters of the patterning device.

Dose control may also be influenced by mechanical adjustments of the patterning device. For example, the dose delivered during a scanning exposure may depend on the relative scanning velocity between the reticle stage and wafer stage and therefore on their precise trajectories. Variations in the Z-position of the reticle or wafer may also affect the effective dose distribution. Accordingly, adjusting dose may include modifying illumination intensity, modifying scan speed, or performing controlled Z-movements of the reticle stage, wafer stage, or projection system components to maintain a desired dose profile across the substrate.

Therefore, in accordance with at least some example, the step of adjusting one or more exposure parameters of the patterning device may comprise adjusting the focus setting by controlling Z/Rx/Ry positions of the reticle stage and/or wafer stage, or adjusting the dose by modifying illumination conditions, scan speed, or Z-movement of one or more subsystems of the patterning device. These mechanical and optical adjustments may act in combination to control how the pattern is transferred to the photoresist.

In a second aspect of the present disclosure, there is provided a method of operating an exposure apparatus in accordance with any of the previous examples, wherein the method comprises the step of adjusting, by the controller, the one or more exposure parameters of the patterning device based on the dimension data, such that dimensions of the plurality of openings to be formed and corresponding exposed sections of the current wafer are adjusted for improving co-planarity of microbumps created in the subsequent volume-additive process.

It is noted that the advantages as explained with reference to the first aspect of the present disclosure, being the exposure apparatus are also applicable to the second aspect of the present disclosure, being the method of operating such an exposure apparatus.

In an example, the table is further arranged for holding the previous wafer and wherein the exposure apparatus comprises a levelling sensor, the method comprises the step of obtaining the dimension data of the plurality of microbumps created in the volume-additive process for the previous wafer.

In a further example, the method comprises the step of spatially aligning the received dimension data of the previous wafer with the plurality of opening to be formed by the patterning device in the current wafer.

In another example, the one or more exposure parameter comprise any of focus settings and dose control.

In yet another example, the method comprises the step of obtaining, by the levelling sensor, surface topography of each of the plurality of section of the wafer through the plurality of openings.

In an even further example, the step of adjusting further comprises adjusting, by the controller, the one or more exposure parameter of the patterning device based on the surface topography.

In an example, the method further comprises the step of receiving, by the controller, Side Wall Angle, SWA, data of the photoresist layer corresponding to each of the plurality of openings.

In another example, the step of adjusting further comprises adjusting, by the controller, the one or more exposure parameter of the patterning device based on the received SWA data.

In an even further example, the exposure apparatus is any of a stepper apparatus or a scanner apparatus.

### BRIEF DESCRIPTION OF THE DRAWINGS

Examples of the present disclosure will now be described, by way of example only, with reference to the accompanying schematic drawings, in which:
Figure 1 shows a lithographic system comprising a radiation source and a lithographic apparatus in accordance with the present disclosure;
Figure 2 shows a cross-section of the wafer with the photoresist layer, in which openings have been formed, and in which the microbumps have been created by electroplating;
Figure 3 shows a cross-section of the wafer with the photoresist layer, in which openings have been formed, and in which the microbumps are to be created by electroplating;
Figure 4 shows a method in accordance with the present disclosure.

### DETAILED DESCRIPTION

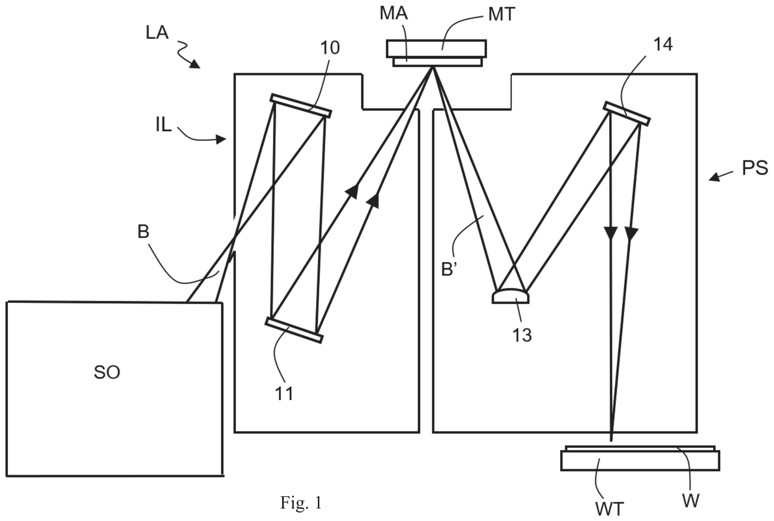

Figure 1 shows an exposure apparatus being a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The facetted field mirror device 10 and facetted pupil mirror device 11 together provide the EUV radiation beam B with a desired cross-sectional shape and a desired intensity distribution. The illumination system IL may include other mirrors or devices in addition to, or instead of, the faceted field mirror device 10 and facetted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g. six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO may be a laser produced plasma (LPP) source, a discharge produced plasma (DPP) source, a free electron laser (FEL) or any other radiation source that is capable of generating EUV radiation.

Where the context allows, examples of the present disclosure may be implemented in hardware, firmware, software, or any combination thereof. Examples of the disclosure may also be implemented as instructions stored on a machine-readable medium, which may be read and executed by one or more processors.

A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

Figure 1 has been described with reference to an EUV based lithographic system. However, it will be understood that the present disclosure is not limited to EUV systems and is equally applicable to other types of lithographic systems, such as Deep Ultraviolet, DUV, based lithographic systems. While EUV systems use radiation with a wavelength of approximately 13.5 nanometers and require a vacuum environment due to the strong absorption of EUV light in air, DUV systems typically use radiation with longer wavelengths and can operate in an atmospheric environment.

DUV lithography often employs transmissive optics and quartz-based masks, whereas EUV lithography relies on reflective optics and multi-layer mirrors due to the high absorption of EUV radiation in most materials. Despite these differences, the methods and apparatuses described herein, particularly those concerning the substrate table, may be employed in both EUV and DUV lithographic systems.

While the concepts disclosed herein may be used for imaging on a silicon wafer, it shall be understood that the disclosed concepts may be used with any type of lithographic imaging systems, e.g., those used for imaging on substrates other than silicon wafers.

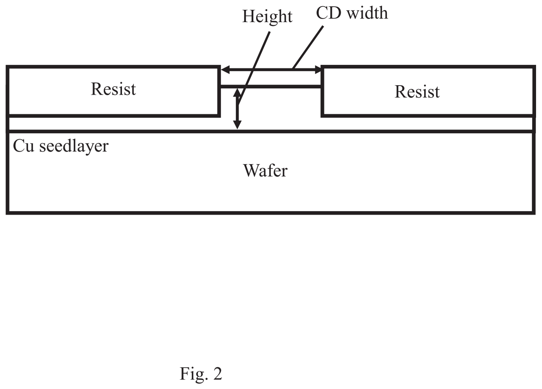

Figure 2 shows a cross-section of the wafer with the photoresist layer, in which openings have been formed, and in which the microbumps have been created by electroplating.

As mentioned above, High Bandwidth Memory, HBM typically consists of stacks of DRAM dies and is an enabling technology driving the current Artificial Intelligence, AI, engine roadmap. One parameter is the number of vertical interconnects between DRAM dies, and also Bottom buffer die. These interconnects are manufactured using microbump technology, for example comprising Cu pillars and solder balls, which electrically connect 2 DRAM dies during stacking.

Faster AI engines require more interconnects and therefore smaller microbumps. In addition, large area packages, for example AI engine, image sensors, are challenged to increase microbump density as well as well as uniform microbump height across the package.

High yielding die stacking by microbump process may require tight co-planarity control. Co-planarity is defined as top surface flatness of the microbumps, i.e. the so-called Cu pillars or Cu pads across an area, for example the wafer or die. With worse co-planarity, a Die2Wafer or Die2Die stacking process will be compromised and yield will be lower.

The present example is explain with respect to an electroplating process as the volume-additive process. It is noted that the present disclosure is not limited to this specific electroplating process. The invention is also applicable to alternative volume-additive processes.

The surface flatness is typically determined by electroplating process height control. The inventors have found that the local Critical Dimension, CD, performance may be of importance. The CD may be defined as the two-dimensional area of the holes created in the photoresist where the microbumps are to be create. The reason is that electroplating is a volume additive process, meaning that the deposited volume may be constant for certain electroplating process settings. The deposition occurs on locations on the wafer where no resist is present. Therefore if the open area has larger x/y dimensions (=CDx and CDy), the thickness of height of the Cu pillar or Cu pad will be lower. So the deposited volume remains constant. In an equation this looks like: Volume of circular pillar =h*pi*(0.5*CD)^2 with h = pillar height and CD = 2* radius of circular pillar.

The height range representing the co-planarity may be of interest, which can be deduces by considering the equation above for a constant volume and different h1, CD1, and h2, CD2 to come to the following approximation: h2 = h1 / (1 +/- 2CDU) with h1, h2 = pillar heights on locations CD1, resp CD2 (and CDU is the delta). As a result the co-planarity is dependent on the CDU performance of the layer that forms the open areas (=windows) in the photoresist.

Figure 1 shows the wafer having a Cu seed layer. The Cu seed layer acts as a promotor for the subsequent electroplating process. The microbumps will then be created on top of the exposed sections of the Cu seed layer.

The patterning device will expose the photoresist according to a pattern such that, after a further processing step of the photoresist layer, a plurality of openings are formed in the photoresist layer, thereby exposing corresponding sections of the current wafer through the plurality of openings. In figure 1, one such opening is disclosed, the wafer is disclosed, the photoresist layer is disclosed, the Cu seedlayer is disclosed, the CD width is disclosed and the microbumps are disclosed.

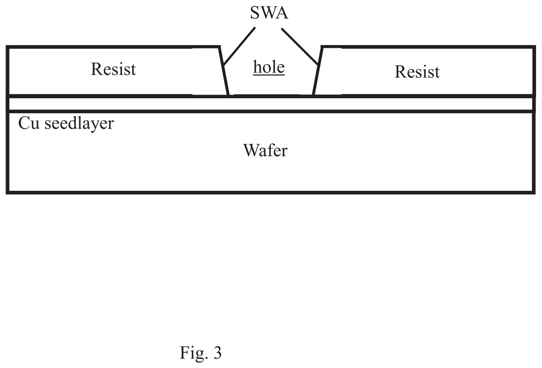

Figure 3 shows a cross-section of the wafer with the photoresist layer, in which openings have been formed, and in which the microbumps are to be created by electroplating.

Figure 3 thus shows the wafer when it is processed by the exposure apparatus and it is ready to be further processed by a volume-additive process.

As mentioned above, the Side Wall Angle, SWA, data of the photoresist layer corresponding to each of the plurality of openings may be received by the exposure apparatus. The inventors have found that the SWA may also contribute to the eventual height of the microbumps that are to be created. It may thus not only depend on the CD width of the hole.

Another aspect that may be considered is the surface topography of the substrate and/or the Cu seedlayer. This may also contribute to the eventual height of the microbumps that are to be formed by the volume-additive process.

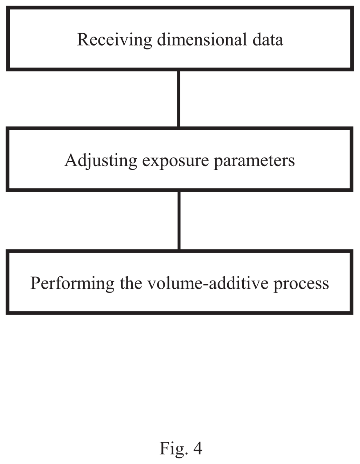

Figure 4 shows a method in accordance with the present disclosure. The method is directed to operating an exposure apparatus in accordance with any of the previous examples, wherein the method comprises the step of receiving the dimension data, and adjusting, by the controller, the one or more exposure parameters of the patterning device based on the dimension data, such that dimensions of the plurality of openings to be formed and corresponding exposed sections of the current wafer are adjusted for improving co-planarity of microbumps created in the subsequent volume-additive process. Finally, the volume-additive process may take place, preferably in a different apparatus.

Aspects of the invention can be implemented in any convenient form. For example, an embodiment may be implemented by one or more appropriate computer programs which may be carried on an appropriate carrier medium which may be a tangible carrier medium (e.g., a disk) or an intangible carrier medium (e.g., a communications signal). Embodiments of the invention may be implemented using suitable apparatus which may specifically take the form of a programmable computer running a computer program arranged to implement a method as described herein. Thus, embodiments of the disclosure may be implemented in hardware, firmware, software, or any combination thereof. Embodiments of the disclosure may also be implemented as instructions stored on a machine-readable medium, which may be read and executed by one or more processors. A machine-readable medium may include any mechanism for storing or transmitting information in a form readable by a machine (e.g., a computing device). For example, a machine -readable medium may include read only memory (ROM); random access memory (RAM); magnetic disk storage media; optical storage media; flash memory devices; electrical, optical, acoustical or other forms of propagated signals (e.g., carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc.

In block diagrams, illustrated components are depicted as discrete functional blocks, but embodiments are not limited to systems in which the functionality described herein is organized as illustrated. The functionality provided by each of the components may be provided by software or hardware modules that are differently organized than is presently depicted, for example such software or hardware may be intermingled, conjoined, replicated, broken up, distributed (e.g., within a data center or geographically), or otherwise differently organized. The functionality described herein may be provided by one or more processors of one or more computers executing code stored on a tangible, non-transitory, machine readable medium. In some cases, third party content delivery networks may host some or all of the information conveyed over networks, in which case, to the extent information (e.g., content) is said to be supplied or otherwise provided, the information may be provided by sending instructions to retrieve that information from a content delivery network.

Unless specifically stated otherwise, as apparent from the discussion, it is appreciated that throughout this specification discussions utilizing terms such as "processing," "computing," "calculating," "determining" or the like refer to actions or processes of a specific apparatus, such as a special purpose computer or a similar special purpose electronic processing/computing device.

Rather than separating those inventions into multiple isolated patent applications, these inventions have been grouped into a single document because their related subject matter lends itself to economies in the application process. But the distinct advantages and aspects of such inventions should not be conflated. In some cases, embodiments address all of the deficiencies noted herein, but it should be understood that the inventions are independently useful, and some embodiments address only a subset of such problems or offer other, unmentioned benefits that will be apparent to those of skill in the art reviewing the present disclosure. Due to cost constraints, some inventions disclosed herein may not be presently claimed and may be claimed in later filings, such as continuation applications or by amending the present claims. Similarly, due to space constraints, neither the Abstract nor the Summary sections of the present document should be taken as containing a comprehensive listing of all such inventions or all aspects of such inventions.

It should be understood that the description and the drawings are not intended to limit the present disclosure to the particular form disclosed, but to the contrary, the intention is to cover all modifications, equivalents, and alternatives falling within the spirit and scope of the inventions as defined by the appended claims.

Modifications and alternative embodiments of various aspects of the inventions will be apparent to those skilled in the art in view of this description. Accordingly, this description and the drawings are to be construed as illustrative only and are for the purpose of teaching those skilled in the art the general manner of carrying out the inventions. It is to be understood that the forms of the inventions shown and described herein are to be taken as examples of embodiments. Elements and materials may be substituted for those illustrated and described herein, parts and processes may be reversed or omitted, certain features may be utilized independently, and embodiments or features of embodiments may be combined, all as would be apparent to one skilled in the art after having the benefit of this description. Changes may be made in the elements described herein without departing from the spirit and scope of the invention as described in the following claims. Headings used herein are for organizational purposes only and are not meant to be used to limit the scope of the description.

As used throughout this application, the word "may" is used in a permissive sense (i.e., meaning having the potential to), rather than the mandatory sense (i.e., meaning must). The words "include", "including", and "includes" and the like mean including, but not limited to. As used throughout this application, the singular forms "a," "an," and "the" include plural referents unless the content explicitly indicates otherwise. Thus, for example, reference to "an" element or "a" element includes a combination of two or more elements, notwithstanding use of other terms and phrases for one or more elements, such as "one or more." As used herein, unless specifically stated otherwise, the term "or" encompasses all possible combinations, except where infeasible. For example, if it is stated that a component may include A or B, then, unless specifically stated otherwise or infeasible, the component may include A, or B, or A and B. As a second example, if it is stated that a component may include A, B, or C, then, unless specifically stated otherwise or infeasible, the component may include A, or B, or C, or A and B, or A and C, or B and C, or A and B and C.

Terms describing conditional relationships, e.g., "in response to X, Y," "upon X, Y,", "if X, Y," "when X, Y," and the like, encompass causal relationships in which the antecedent is a necessary causal condition, the antecedent is a sufficient causal condition, or the antecedent is a contributory causal condition of the consequent, e.g., "state X occurs upon condition Y obtaining" is generic to "X occurs solely upon Y" and "X occurs upon Y and Z." Such conditional relationships are not limited to consequences that instantly follow the antecedent obtaining, as some consequences may be delayed, and in conditional statements, antecedents are connected to their consequents, e.g., the antecedent is relevant to the likelihood of the consequent occurring. Statements in which a plurality of attributes or functions are mapped to a plurality of objects (e.g., one or more processors performing steps A, B, C, and D) encompasses both all such attributes or functions being mapped to all such objects and subsets of the attributes or functions being mapped to subsets of the attributes or functions (e.g., both all processors each performing steps A-D, and a case in which processor 1 performs step A, processor 2 performs step B and part of step C, and processor 3 performs part of step C and step D), unless otherwise indicated. Further, unless otherwise indicated, statements that one value or action is "based on" another condition or value encompass both instances in which the condition or value is the sole factor and instances in which the condition or value is one factor among a plurality of factors. Unless otherwise indicated, statements that "each" instance of some collection have some property should not be read to exclude cases where some otherwise identical or similar members of a larger collection do not have the property, i.e., each does not necessarily mean each and every. References to selection from a range includes the end points of the range.

Further aspects of the invention are set out in the following clauses:
1. An exposure apparatus arranged for preparing a current wafer for creation of microbumps in a subsequent volume-additive process, wherein the exposure apparatus comprises:
   - a wafer table arranged for holding the current wafer having a photoresist layer provided on top of the wafer,
   - a patterning device arranged for exposing the photoresist according to a pattern such that, after a further processing step of the photoresist layer, a plurality of openings in the photoresist layer are formed, thereby exposing corresponding sections of the current wafer;
   - a controller arranged for:
      - receiving dimension data of a plurality of microbumps created in a volume-additive process for a previous wafer;
      - adjusting one or more exposure parameters of the patterning device based on the dimension data, such that dimensions of the plurality of the plurality of openings to be formed and corresponding exposed sections of the current wafer are adjusted for improving co-planarity of microbumps created in the subsequent volume-additive process.
2. An exposure apparatus in accordance with clause 1, wherein the wafer table is further arranged for holding the previous wafer and wherein the exposure apparatus comprises:
   - a levelling sensor arranged for obtaining the dimension data of the plurality of microbumps created in the volume-additive process for the previous wafer.
3. An exposure apparatus in accordance with any of the previous clauses, wherein the controller is further arranged for spatially aligning the received dimension data of the previous wafer with the plurality of openings to be formed by the patterning device in the current wafer.
4. An exposure apparatus in accordance with any of the previous clauses, wherein the one or more exposure parameters comprise any of:
   - focus settings;
   - dose control.
5. An exposure apparatus in accordance with any of the previous clauses, wherein the wafer table is arranged for holding the wafer comprising a seed layer, wherein the photoresist layer is provided on top of the seed layer, wherein the seed layer is arranged to enabling microbumps to be created in a subsequent electroplating process.
6. An exposure apparatus in accordance with any of the previous clauses, and at least clause 2, wherein the levelling sensor is further arranged for obtaining surface topography of each of the plurality of sections of the wafer through the plurality of openings.
7. An exposure apparatus in accordance with clause 6, wherein the controller is further arranged for adjusting the one or more exposure parameter of the patterning device based on the surface topography.
8. An exposure apparatus in accordance with any of the previous clauses, wherein the controller is further arranged for receiving Side Wall Angle, SWA, data of the photoresist layer corresponding to each of the plurality of openings.
9. An exposure apparatus in accordance with clause 8, wherein the controller is further arranged for adjusting the one or more exposure parameter of the patterning device based on the received SWA data.
10. An exposure apparatus in accordance with any of the previous clauses, wherein the exposure apparatus is any of:
   - a stepper apparatus;
   - a scanner apparatus.
11. An exposure apparatus in accordance with clause 10, wherein the exposure apparatus is the scanner apparatus, and wherein the scanner apparatus comprises:
   - a levelling sensor for mapping wafer surface thereby obtaining wafer topography;
   and wherein the controller is configured adjust focus and/or tilt of the patterning device during scanning exposure based on the obtained wafer topography map, thereby exposing photoresist according to the pattern.
12. A method of operating an exposure apparatus in accordance with any of the previous clauses, wherein the method comprises the step of:
   - adjusting, by the controller, the one or more exposure parameters of the patterning device based on the dimension data, such that dimensions of the plurality of openings to be formed and corresponding exposed sections of the current wafer are adjusted for improving co-planarity of microbumps created in the subsequent volume-additive process.
13. A method in accordance with clause 12, wherein the table is further arranged for holding the previous wafer and wherein the exposure apparatus comprises a levelling sensor, the method comprises the step of:
   - obtaining the dimension data of the plurality of microbumps created in the volume-additive process for the previous wafer.
14. A method in accordance with any of the clauses 11 - 13, wherein the method comprises the step of:
   - spatially aligning the received dimension data of the previous wafer with the plurality of opening to be formed by the patterning device in the current wafer
15. A method in accordance with any of the clauses 11 - 14, wherein the one or more exposure parameter comprise any of:
   - focus settings;
   - dose control.
16. A method in accordance with any of the clauses 11 - 15, and at least clause 13, wherein the method comprises the step of:
   - obtaining, by the levelling sensor, surface topography of each of the plurality of section of the wafer through the plurality of openings.
17. A method in accordance with clause 16, wherein the step of adjusting further comprises:
   - adjusting, by the controller, the one or more exposure parameter of the patterning device based on the surface topography.
18. A method in accordance with any of the clauses 11 - 17, wherein the method further comprises the step of:
   - receiving, by the controller, Side Wall Angle, SWA, data of the photoresist layer corresponding to each of the plurality of openings.
19. A method in accordance with clause 18, wherein the step of adjusting further comprises:
   - adjusting, by the controller, the one or more exposure parameter of the patterning device based on the received SWA data.

In the above description, any processes, descriptions or blocks in flowcharts should be understood as representing modules, segments or portions of code which include one or more executable instructions for implementing specific logical functions or steps in the process, and alternate implementations are included within the scope of the exemplary embodiments of the present advancements in which functions can be executed out of order from that shown or discussed, including substantially concurrently or in reverse order, depending upon the functionality involved, as would be understood by those skilled in the art.

While certain embodiments have been described, these embodiments have been presented by way of example only, and are not intended to limit the scope of the present disclosures. Indeed, the novel methods, apparatuses and systems described herein can be embodied in a variety of other forms; furthermore, various omissions, substitutions and changes in the form of the methods, apparatuses and systems described herein can be made without departing from the spirit of the present disclosures. The accompanying claims and their equivalents are intended to cover such forms or modifications as would fall within the scope and spirit of the present disclosures.

## Claims

1. An exposure apparatus arranged for preparing a current wafer for creation of microbumps in a subsequent volume-additive process, wherein the exposure apparatus comprises:
- a wafer table arranged for holding the current wafer having a photoresist layer provided on top of the wafer,
- a patterning device arranged for exposing the photoresist according to a pattern such that, after a further processing step of the photoresist layer, a plurality of openings in the photoresist layer are formed, thereby exposing corresponding sections of the current wafer;
- a controller arranged for:
- receiving dimension data of a plurality of microbumps created in a volume-additive process for a previous wafer;
- adjusting one or more exposure parameters of the patterning device based on the dimension data, such that dimensions of the plurality of the plurality of openings to be formed and corresponding exposed sections of the current wafer are adjusted for improving co-planarity of microbumps created in the subsequent volume-additive process.

2. An exposure apparatus in accordance with claim 1, wherein the wafer table is further arranged for holding the previous wafer and wherein the exposure apparatus comprises:
- a levelling sensor arranged for obtaining the dimension data of the plurality of microbumps created in the volume-additive process for the previous wafer.

3. An exposure apparatus in accordance with any of the previous claims, wherein the controller is further arranged for spatially aligning the received dimension data of the previous wafer with the plurality of openings to be formed by the patterning device in the current wafer.

4. An exposure apparatus in accordance with any of the previous claims, wherein the wafer table is arranged for holding the wafer comprising a seed layer, wherein the photoresist layer is provided on top of the seed layer, wherein the seed layer is arranged to enabling microbumps to be created in a subsequent electroplating process.

5. An exposure apparatus in accordance with any of the previous claims, and at least claim 2, wherein the levelling sensor is further arranged for obtaining surface topography of each of the plurality of sections of the wafer through the plurality of openings.

6. An exposure apparatus in accordance with any of the previous claims, wherein the controller is further arranged for receiving Side Wall Angle, SWA, data of the photoresist layer corresponding to each of the plurality of openings and wherein the controller is further arranged for adjusting the one or more exposure parameter of the patterning device based on the received SWA data.

7. An exposure apparatus in accordance with any of the previous claims, wherein the exposure apparatus is a scanner apparatus, and wherein the scanner apparatus comprises:
- a levelling sensor for mapping wafer surface thereby obtaining wafer topography;
and wherein the controller is configured adjust focus and/or tilt of the patterning device during scanning exposure based on the obtained wafer topography map, thereby exposing photoresist according to the pattern.

8. A method of operating an exposure apparatus in accordance with any of the previous claims, wherein the method comprises the step of:
- adjusting, by the controller, the one or more exposure parameters of the patterning device based on the dimension data, such that dimensions of the plurality of openings to be formed and corresponding exposed sections of the current wafer are adjusted for improving co-planarity of microbumps created in the subsequent volume-additive process.

9. A method in accordance with claim 8, wherein the table is further arranged for holding the previous wafer and wherein the exposure apparatus comprises a levelling sensor, the method comprises the step of:
- obtaining the dimension data of the plurality of microbumps created in the volume-additive process for the previous wafer.

10. A method in accordance with claim 9, wherein the method comprises the step of:
- obtaining, by the levelling sensor, surface topography of each of the plurality of section of the wafer through the plurality of openings.

11. A method in accordance with claim 10, wherein the step of adjusting further comprises:
- adjusting, by the controller, the one or more exposure parameter of the patterning device based on the surface topography.

12. A method in accordance with any of the claims 9 - 11, wherein the method further comprises the step of:
- receiving, by the controller, Side Wall Angle, SWA, data of the photoresist layer corresponding to each of the plurality of openings.

13. A method in accordance with claim 12, wherein the step of adjusting further comprises:
- adjusting, by the controller, the one or more exposure parameter of the patterning device based on the received SWA data.
